(19) Europäisches Patentamt / European Patent Office / Office européen des brevets

(11) **EP 2 293 091 A2**

(12) **DEMANDE DE BREVET EUROPEEN**

(43) Date de publication:
**09.03.2011 Bulletin 2011/10**

(51) Int Cl.:
*G01R 31/36* (2006.01)      *H01M 10/48* (2006.01)

(21) Numéro de dépôt: **10290401.8**

(22) Date de dépôt: **16.07.2010**

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**
Etats d'extension désignés:
**BA ME RS**

(30) Priorité: **02.09.2009  FR 0904161**

(71) Demandeur: **IFP Energies Nouvelles**
**92852 Rueil-Malmaison Cedex (FR)**

(72) Inventeurs:
• **Prada, Eric**
  **69007 Lyon (FR)**
• **Sauvant-Moynot, Valérie**
  **69006 Lyon (FR)**

(54) **Méthode pour simuler le comportement thermique d'un système électrochimique**

(57)    La présente invention concerne une méthode de simulation du comportement thermique d'un système électrochimique à l'aide d'un modèle mathématique multidimensionnel permettant notamment de coupler les comportements électriques et thermiques d'une batterie en fonctionnement. La reconstruction des caractéristiques thermiques de la batterie est faite à travers l'utilisation d'un modèle mathématique multidimensionnel de la batterie utilisant la technique des éléments finis, le flux thermique étant généré en chaque point de l'espace par un modèle électrochimique de la batterie à paramètres concentrés (modèle zéro-dimensionnel). La méthode peut être utilisée hors ligne, par exemple dans le cadre du dimensionnement de la batterie, et notamment de son système de refroidissement. La méthode peut également être utile d'une façon synchrone au fonctionnement en temps réel de la batterie pour estimer la température interne d'un élément, par exemple lors d'une recharge rapide.

Figure 2

EP 2 293 091 A2

## Description

La présente invention concerne une méthode pour simuler le comportement thermique d'un système électrochimique, par exemple du type batterie, à l'aide d'un modèle mathématique multidimensionnel permettant notamment de coupler les comportements électriques et thermiques du système électrochimique en fonctionnement.

La méthode peut être utilisée hors ligne, par exemple dans le cadre du dimensionnement de la batterie, du dimensionnement de son système de refroidissement, ou plus généralement dans le cadre de l'optimisation des stratégies de gestion énergétique et thermique en fonction de l'application visée. La méthode peut également être utile d'une façon synchrone au fonctionnement de la batterie elle-même (temps réel) pour estimer la température interne d'un élément, par exemple lors d'une recharge rapide.

La batterie électrochimique est l'un des composants les plus critiques d'un véhicule hybride ou électrique. L'état de charge d'une batterie (SoC) est sa capacité disponible, exprimée en pourcentage de sa capacité nominale. La connaissance du SoC permet d'estimer combien de temps la batterie pourra continuer à fournir de l'énergie à une intensité donnée, ou jusqu'à quand elle pourra en absorber.

Pendant la vie d'une batterie, ses performances tendent à se dégrader graduellement à cause des variations physiques et chimiques qui ont lieu avec l'usage, et jusqu'à rendre la batterie inutilisable. L'état de santé (SoH), qui est la capacité disponible après une recharge (exprimée en Ah), est donc une mesure du point qui a été atteint dans le cycle de vie de la batterie.

Le dimensionnement de la batterie rechargeable au sein de l'architecture d'un véhicule repose sur une simulation de la batterie qui vise à représenter précisément son comportement électrique et thermique à différents niveaux de sollicitation dynamique. La température est le facteur prépondérant conditionnant le fonctionnement des systèmes de stockage en raison du caractère thermiquement activé des cinétiques de réactions chimiques et de diffusion au sein d'un élément de batterie ou cellule. De ce fait, c'est un facteur de vieillissement des éléments constituant les systèmes de stockage. En outre, il y a un risque d'emballement thermique des batteries au delà d'une certaine température. Le fonctionnement optimisé de la batterie, en termes sécuritaire, fonctionnels, et de durée de vie, s'appuie sur la stratégie de gestion thermique mise en oeuvre dans le véhicule. La connaissance précise et fiable de l'état thermique d'une batterie, c'est-à-dire des gradients de température internes à chaque élément, mais aussi au sein de l'ensemble ("pack"), suivant les niveaux de sollicitation en courant de la batterie et de la température ambiante, est indispensable pour dimensionner une cellule, ou un ensemble de cellules ("pack"), et son système de refroidissement.

L'état thermique d'une batterie conditionne ses performances, car les réactions chimiques et phénomènes de transport mis en jeu dans les systèmes électrochimiques sont thermiquement activés. L'état thermique initial est lié à la température extérieure au véhicule, qui peut être amené à fonctionner sur une large plage de températures, typiquement entre -30°C et +50°C. L'état thermique en service évolue en fonction de la sollicitation en charge et décharge de la batterie, de sa conception et de son environnement. Il s'instaure ainsi des phénomènes de gradient thermique au cours du fonctionnement d'une batterie, gradients internes aux éléments, mais aussi entre éléments.

Les gradients thermiques internes résultent d'un effet coeur/peau entre la surface extérieure de l'enveloppe de la batterie (peau) qui est généralement refroidie par un fluide de refroidissement (effet convectif), et la matière constitutive de l'élément de batterie (coeur) qui n'a pas les mêmes propriétés thermiques que l'enveloppe, et qui n'est pas refroidie par convection mais par principalement par simple conduction.

A l'échelle de l'élément de batterie, ces gradients thermiques internes génèrent des gradients de l'état de charge, voire de l'état de santé, dans les matériaux d'électrodes au sein d'un élément, puisque les cinétiques électrochimiques et les phénomènes diffusifs qui s'y déroulent sont thermiquement activés. Aussi, il faut minimiser les gradients thermiques internes pour conserver des performances fonctionnelles (puissance et énergie) optimisées à l'échelle de l'élément, et assurer un fonctionnement en toute sécurité, alors que seule la température de peau est facilement mesurable.

A l'échelle du pack de batterie (ensemble de cellules ou éléments), les gradients thermiques entre éléments dépendent de la position de chaque élément dans le pack, de la géométrie du flux de refroidissement, mais aussi de la connectique entre les éléments et de l'électronique au sein du pack. Tous ces facteurs contribuent notoirement à l'échauffement général de la batterie. Les gradients thermiques entre éléments génèrent des différences de performances fonctionnelles (puissance et énergie) au sein du pack. Aussi, il convient de minimiser les gradients entre éléments de façon à assurer un fonctionnement et un vieillissement homogènes au sein du pack - alors même que l'état de charge et l'état de santé d'un élément de batterie ne sont pas des grandeurs mesurables. Il est donc primordial de pouvoir simuler le comportement thermique du système électrochimique.

## Art antérieur

D'une manière générale, il existe deux grandes catégories de modèles du comportement électrique et thermique des batteries permettant de simuler les systèmes électrochimiques : d'une part les modèles électrochimiques, inspirés des travaux de Newman, reposant sur la connaissance des réactions chimiques et phénomènes physico-chimiques qui ont lieu à l'échelle microscopique dans la cellule de batterie ; d'autre part les modèles à circuit électrique équivalent, constitués d'éléments électriques tels que des résistances, capacités, inductances, agencés en série et/ou en parallèle, visant à représenter au mieux la dynamique du comportement d'une batterie.

La modélisation du comportement de batterie par analogie électrique est la plus courante, car il s'agit de modèles intuitifs, à paramètres concentrés (i.e. dépendants seulement du temps), donc peu gourmands en temps de calcul. Les éléments électriques, le plus souvent identifiés par une mesure physique, sont paramétrés par l'état de charge SoC, l'état de santé SoH, la température, et la valeur du courant (données sous forme de cartographies).

L'utilisation de modèles RC est décrite dans le brevet EP880710 (Philips), la description des phénomènes électrochimiques et physiques aux électrodes et dans l'électrolyte servant de support au développement du modèle RC, la température de la batterie étant simulée par le modèle, afin de gagner en précision, par rapport à une mesure externe. Néanmoins, il n'est pas possible de simuler les gradients de température internes aux éléments puisqu'il s'agit d'une approche à paramètres concentrés (pas de dépendance spatiale des variables).

Dans les modèles électrochimiques, les équations de la cinétique des principales réactions électrochimiques complétées par le bilan des masses et des charges à l'échelle d'un élément constituent un système d'équations différentielles, dont la résolution donne en chaque instant la concentration des espèces actives. L'état de charge (SoC) est défini à partir des concentrations des espèces actives aux électrodes, donc à partir de variables d'état du système. Des cinétiques de vieillissement peuvent être également intégrées, afin de calculer l'état de santé (SoH). Suivant la précision de modèle souhaitée, l'élément peut être maillé de manière multidimensionnelle (modèles 2D ou 3D), unidirectionnelle (1D), ou bien être considéré comme un milieu homogène (modèle 0D "à paramètres concentrés").

Dans l'approximation à paramètres concentrés, le temps de calcul est minimum, mais il n'est pas possible de simuler les gradients de température internes aux éléments.

En revanche, les modèles électrochimiques 1D, 2D voire 3D, qui permettent théoriquement le calcul des variables internes du système à chaque maille et à chaque pas de temps, conduisent rapidement à un système d'équations algébro-différentielles très complexe à gérer et extrêmement gourmand en temps de calcul, puisque le nombre d'équations est à multiplier par le nombre de mailles. Il n'est pas possible pour l'Homme du métier d'envisager un simulateur efficace de l'état thermique d'une batterie, donnant la température en tout point de l'espace, qui soit basé sur cette approche.

De manière surprenante, la méthode suivant l'invention propose une approche qui combine les avantages d'un modèle multidimensionnel utilisant les éléments finis, aux avantages d'une modélisation électrochimique 0D de batterie couplant les aspects électrique et thermique, de façon à simuler le comportement thermique d'une batterie de manière fine, notamment les gradients thermiques internes aux éléments et les gradients entre éléments, et ce, de façon quasi synchrone au fonctionnement de la batterie.

**Objets de l'invention:**

La présente invention concerne une méthode de simulation du comportement thermique d'un système électrochimique rechargeable (de type batterie), à partir d'un modèle mathématique multidimensionnel de la batterie utilisant un maillage par la technique des éléments finis et un modèle électrochimique zéro-dimensionnel (0D) du système électrochimique au sein de chaque maille considérée comme homogène.

L'invention concerne également un système intelligent de gestion énergétique et thermique de la batterie pendant son fonctionnement, par exemple lors d'une recharge rapide.

La méthode selon l'invention peut aussi être utilisée pour la conception d'une batterie en permettant un dimensionnement, des calibrations, validations, etc...

L'invention concerne également un simulateur du comportement thermique et électrique d'un système électrochimique utilisant la méthode selon l'invention.

La méthode selon l'invention peut également être utilisée dans un simulateur du système véhicule hybride ou électrique comportant une batterie de traction.

Un autre objet de l'invention est un chargeur/déchargeur de batterie utilisant la méthode selon l'invention.

**Description de l'invention**

Ainsi, l'invention concerne une méthode de simulation du comportement thermique d'un système électrochimique rechargeable comportant des électrodes, un séparateur et un électrolyte, dans laquelle on dispose d'au moins un signal d'entrée d'au moins un paramètre représentatif d'une quantité physique dudit système, et on établit un modèle électrochimique dudit système comprenant au moins :

■ une représentation mathématique d'une cinétique de réactions électrochimiques ayant lieu aux interfaces entre chacune des électrodes et l'électrolyte, ladite représentation prenant en compte des concentrations d'interface,

■ une représentation mathématique d'une accumulation spatiale de capacité de double couche de charges à chaque électrode,

■ une représentation mathématique d'une redistribution de charges à chacune des électrodes,

■ une représentation mathématique d'une diffusion de charges ioniques de l'électrolyte au travers desdites électrodes et dudit séparateur,

■ un bilan de matière dans toutes phases du système,

■ un bilan énergétique du système, pour calculer une température dudit système électrochimique,

Selon l'invention, le modèle électrochimique est un modèle à paramètres concentrés dans lequel les paramètres sont homogènes au sein des électrodes et au sein su séparateur. La méthode comporte les étapes suivantes :

○ on définit un maillage spatial du système électrochimique en découpant ledit système en éléments géométriques de petites dimensions,

○ on établit un modèle mathématique multidimensionnel dudit système électrochimique par la technique des éléments finis en discrétisant des équations comportementales dudit système en chaque maille dudit maillage spatial,

○ on génère un flux thermique en chaque maille par ledit modèle électrochimique en fonction de réactions chimiques endothermiques ou exothermiques, ledit flux étant intégré à chaque pas de temps en fonction de caractéristiques thermiques et géométriques dudit système,

○ on calcule des variables caractéristiques dudit système à chaque pas de temps et en chaque maille,

○ on simule ledit comportement thermique du système électrochimique en générant au moins un signal de sortie représentatif du comportement thermique du système à partir desdites variables caractéristiques du système.

Selon un mode de réalisation, le modèle électrochimique tient compte d'un vieillissement du système électrochimique en déterminant une diminution de concentration maximale d'espèces stockées dans les électrodes, et une augmentation d'une résistance interne du système électrochimique.

La diminution de concentration maximale $[X]_{max}$ peut être déterminée au moyen de la formule suivante :

$$\frac{d}{dt}[X]_{\text{max}} = -\chi_{electrode}\left|J_{para,z}\right|$$

dans laquelle $\chi_{electrode}$ est une grandeur fonctionnelle caractéristique de matériaux constituant chaque électrode, t représente le temps, et $|J_{para,z}|$ représente une densité de courant de transfert de charge parasite pour une réaction z.

L'augmentation de résistance interne $R_{layer}$ peut être déterminée au moyen de la formule suivante :

$$\frac{d}{dt}R_{layer} = \pm\chi_{layer}\left|J_{para,z}\right|$$

dans laquelle $\chi_{layer}$ est une grandeur fonctionnelle caractéristique d'une composition chimique de couches parasites formées en surface des électrodes par réactivité avec l'électrolyte, le signe +/- dépendant du mécanisme physico-chimique de développement de couche de surface, t représente le temps, et $|J_{para,z}|$ représente une densité de courant de transfert de charge parasite pour une réaction z.

Selon l'invention, le système électrochimique rechargeable peut comporter également un compartiment destiné à recueillir des espèces gazeuses, et lesdits paramètres sont homogènes au sein dudit compartiment.

On peut distinguer la concentration interfaciale et la concentration moyenne C=f(t) pour chaque espèce active dans chaque région du système électrochimique dans le modèle 0D.

On peut décrire le potentiel d'équilibre thermodynamique de chaque électrode du modèle 0D par une relation mathématique thermodynamique (Nernst, Margules, Van Laar, Redlich-Kister) ou analytique (par exemple: polynomiale ou exponentielle ou autres).

On peut recueillir comme signal de sortie: le potentiel, et/ou l'état de charge, et/ou l'état de santé, et/ou la température, en tout point de l'espace du système électrochimique.

L'invention concerne également un simulateur du comportement thermique d'une batterie électrochimique comprenant :

○ un moyen d'entrée pour recevoir une valeur d'entrée d'au moins un paramètre représentatif d'une quantité physique d'une batterie;

○ un moyen de traitement pour obtenir au moins une caractéristique de sortie calculée par la méthode selon l'invention.

L'invention concerne également un système de gestion intelligent d'une batterie électrochimique comprenant:

- un moyen d'entrée connecté à un moyen de mesure sur la batterie pour recevoir une valeur d'entrée d'au moins un paramètre représentatif d'une quantité physique de la batterie,

- un moyen de traitement pour obtenir au moins un signal de sortie d'au moins une caractéristique calculée par la méthode selon l'invention décrite ci-dessus,

- un moyen de contrôle pour commander la charge/décharge et/ou le refroidissement de la batterie en réponse au signal de sortie du moyen de traitement et/ou de comparaison.

Ledit moyen de traitement du système de gestion peut comprendre un filtre récursif, par exemple du type Kalman.

On peut utiliser ledit système de gestion pour le contrôle et la gestion d'énergie d'un système électrochimique rechargeable d'un véhicule électrique ou hybride, ou d'une installation de fourniture d'énergie photovoltaïque ou éolien.

On peut utiliser ledit système de gestion pour le contrôle et la gestion d'un chargeur/déchargeur.

On peut utiliser la méthode selon l'invention pour simuler le comportement thermique et électrique d'un système électrochimique rechargeable d'un véhicule électrique ou hybride, ou d'une installation de fourniture d'énergie photovoltaïque ou éolien.

On peut utiliser la méthode selon l'invention pour le dimensionnement et la conception d'ensemble d'une batterie. Également, on peut utiliser la méthode pour l'établissement des moyens de gestion thermique de refroidissement et/ou de chauffage d'une batterie.

Description détaillée de l'invention

Dans la modélisation multidimensionnelle par éléments finis de la méthode selon l'invention, les phénomènes thermiques et électriques sont pris en compte dans chaque maille par un modèle électrochimique 0D du système électrochimique (ou plus spécifiquement de la batterie).

Le modèle électrochimique 0D (suivant l'approximation à paramètres concentrés ou approximation homogène dite zéro-dimensionnelle) comprend une description mathématique des réactions de la batterie qui permet de rendre compte de son comportement dynamique (électrique et thermique), sous courant fort et sous courant nul, avec une précision accrue.

Le flux thermique est généré en chaque point de l'espace par le modèle électrochimique 0D en fonction des réactions chimiques endothermiques ou exothermiques. Il est intégré à chaque pas de temps en fonction des caractéristiques thermiques du système (conductivité thermique, capacité thermique des matériaux) et géométriques. Les transferts thermiques à l'intérieur du système font intervenir le phénomène de conduction et les transferts avec l'extérieur (limites géométriques) sont modulables via les équations de conduction et de convection du fluide de refroidissement considéré (par exemple l'air, l'eau avec ou sans glycol).

La méthode selon l'invention permet donc de simuler l'évolution de variables qui correspondent à des données physiques de la batterie non mesurables au cours de son fonctionnement, comme par exemple la température interne à chaque élément ; en conséquence, l'instauration d'un gradient de température au sein d'un élément, et d'un gradient de SoC et de SoH peut être simulée finement.

La méthode selon l'invention peut donc être utilisée hors ligne dans un simulateur du comportement électrique et thermique d'une batterie, par exemple dans le cadre du dimensionnement de conception de la batterie pour une application donnée, du dimensionnement de son système de refroidissement, ou bien d'une calibration, d'une optimisation ou d'une validation des stratégies de gestion énergétique et thermique de la batterie.

La méthode selon l'invention peut également être utile d'une façon synchrone au fonctionnement de la batterie elle-même (temps réel) pour estimer l'état de température de la batterie, externe ou interne aux éléments, par exemple lors d'une recharge rapide

**Principe de la modélisation par éléments finis**

La modélisation par éléments finis d'un système consiste à résoudre les équations de la physique en tout point de l'espace de la géométrie du système étudié. La discrétisation des équations comportementales du système physique en chaque point de l'espace, par la mise en place d'un maillage spatial (1D, 2D ou 3D) plus ou moins complexe, permet à chaque pas de temps et en chaque maille de l'espace, de calculer les variations des variables caractéristiques du système (Température, Potentiel, Concentration d'espèce active).

Le maillage revient à découper le système en éléments géométriques de petites dimensions (triangles par exemple). Chaque maille est en contact avec sa voisine au niveau d'une arête et chaque arête se recoupe en un noeud du maillage (point de l'espace) où s'effectueront les résolutions des équations discrétisées à chaque pas de temps. Cette résolution se fait grâce à des algorithmes mathématiques de résolution numérique ("solveurs") choisis en fonction du conditionnement mathématique du problème physique à résoudre. L'emploi de conditions initiales et de conditions aux limites, aux frontières du système, permet de résoudre le système d'équations en chaque noeud du maillage, à chaque pas de temps. Les conditions initiales reflètent l'état initial dans lequel se trouve le système, et les conditions aux limites reflètent les limites physiques de fonctionnement aux bords géométriques du système maillé.

**Modèle électrochimique à paramètres concentrés ou zéro-dimensionnel (0D)**

Développement d'un modèle électrochimique 0D de batterie

Dans chaque maille du système, on modélise le comportement thermique de l'élément de batterie à l'aide d'un modèle électrochimique 0D à paramètres concentrés.

Le modèle électrochimique dit à paramètres concentrés (ou réduit), repose sur l'hypothèse que les concentrations des espèces et les autres variables sont homogènes dans chacune des régions de la cellule de batterie correspondant typiquement aux électrodes, au séparateur, et au compartiment destiné à recueillir les espèces gazeuses. C'est ce qui est dénommé : l'approximation homogène zéro-dimensionnelle (0D).

Les équations permettant la mise en oeuvre du modèle zéro-dimensionnel utilisé dans la méthode selon l'invention sont explicitées ci-après.

Des réactions électrochimiques ont lieu aux interfaces entre les électrodes et l'électrolyte. L'électrode positive est le siège de réactions électrochimiques de réduction des espèces oxydantes, pendant la décharge, alors que l'électrode négative est le siège de réactions d'oxydation des espèces réductrices. L'équation généralisée des réactions électrochimiques entre des espèces Réactives R et Produites P est présentée dans la relation (1)

$$\sum_{i=1}^{N} r_i R_i + ne^- \quad \overset{r\acute{e}d\rightarrow}{\underset{\leftarrow ox}{\Longleftrightarrow}} \quad \sum_{j=1}^{N'} p_j P_j \qquad (1)$$

La cinétique des réactions électrochimiques peut être décrite par les équations de Butler-Volmer, dont la forme générale pour la réaction générique "z" est :

$$J_{ins,z}(t,T) = J_{z,0}\left\{\frac{\prod_{j=1}^{N'}[P_j]_t^{O^{p'}}}{\prod_{j=1}^{N'}[P_j]_{ref}^{O^n}}\exp\left(\alpha_{ox,z}nK\eta_z(t)\right) - \frac{\prod_{i=1}^{N}[R_i]_t^{O^n}}{\prod_{i=1}^{N}[R_i]_{ref}^{O^n}}\exp\left(-\alpha_{red,z}nK\eta_z(t)\right)\right\}\exp\left(\frac{E_{a,z}}{R}\left(\frac{1}{T}-\frac{1}{T_0}\right)\right) \quad (2)$$

où

$$\eta_z = \phi_{z,electrode} - U_{eq,z} - \phi_{layer,z} \quad (3)$$

dans laquelle $J_{ins,z}$ est la densité de courant de transfert de charge (insertion), $J_{z,0}$ est la densité de courant d'échange électronique, $[X]^0$ est la concentration de l'espèce X produite (P) ou consommée (R) à la surface d'une particule de matériau d'électrode, $\eta_z(t)$ est la surtension d'électrode définie comme la différence de potentiel électrique à l'interface immédiate électrode/électrolyte entre $\Phi_{z,electrode}$ le potentiel à l'électrode considérée, $U_{eq,z}$ le potentiel d'équilibre thermodynamique et $\Phi_z$ un terme de surtension supplémentaire dû à la présence possible d'une couche d'accumulation des charges à la surface des grains de matière active. K est une fonction de la température T et T0 est la température de référence (298K) (K = F / RT), et $E_{a,z}$ est l'énergie d'activation de la réaction électrochimique considérée.

La forme du potentiel d'équilibre thermodynamique $U_{eq,z}$ peut prendre la forme d'expressions mathématiques complexes, décrites par les lois de Nernst, de Margules, de Van Laar ou bien de Redlich-Kister. Ces expressions sont paramétrées en fonction du taux d'avancement de la réaction électrochimique au sein de l'électrode et peuvent aussi prendre la forme de fonctions mathématiques polynomiales, exponentielles, hyperboliques. Les phénomènes d'hystérésis aux électrodes, s'il en est, sont pris en compte par l'équation (4) :

$$\frac{dU_{eq,z}}{dt} = \left(U_{eq,z,\infty} - U_{eq,z}\right)k(I_{app}).\left|I_{app}\right|$$

$$k\left(I_{app}\right) = \begin{cases} kc, I_{app} > 0 \\ kd, I_{app} < 0 \end{cases} \quad (4)$$

$$U_{eq,z,\infty} = \begin{cases} Ueq,z,c, I_{app} > 0 \\ Ueq,z,d, I_{app} < 0 \end{cases}$$

dans lesquelles les indices c et d sont relatifs aux processus de charge et décharge respectivement.

Bilan de matière

Le stockage de l'énergie électrique en énergie électrochimique intervenant au cours d'une réaction z se modélise à l'aide des équations générales de la cinétique électrochimique explicitées ci-dessus et d'un bilan de matière qui prend la forme d'une équation différentielle entre la densité de courant de transfert de charge et la concentration volumique d'une espèce électrochimique X au sein d'une particule de matériau d'électrode selon l'équation (5) :

$$\frac{d}{dt}[X] = -\beta_{electrode} J_{ins,z} \quad (5)$$

dans laquelle $\beta_{electrode}$ est une grandeur fonctionnelle caractéristique du matériau d'électrode et homogène à une longueur de diffusion.

Afin de déterminer la concentration en surface $[X]^0$ d'une particule de matériau d'électrode, une relation pseudo-diffusionnelle de type linéaire est utilisée pour rendre compte du déplacement de l'espèce X dans les particules de matériau d'électrode à partir de la concentration volumique de l'espèce X selon l'équation (6) :

$$[X]^0 - [X] = -J_{ins,z} \times \psi_{electrode} \frac{1}{D_{s,z}} \qquad (6)$$

dans laquelle $\psi_{electrode}$ est une grandeur fonctionnelle caractéristique du matériau d'électrode et proportionnelle à une longueur de diffusion, $D_{s,z}$ est le coefficient de diffusion de l'espèce X dans le matériau d'électrode.

Bilan des charges

- Représentation mathématique de l'accumulation de double couche électrique des charges à chacune des électrodes dans le modèle électrochimique 0D:

En prenant en compte l'accumulation des charges à chaque électrode, la méthode selon l'invention étend le domaine de validité du modèle électrochimique 0D aux cas non-stationnaires, où des effets capacitifs aux interfaces solide-liquide sont importants comme par exemple l'"effet double couche". L'équation (7) retranscrit la prise en compte de la capacité de double couche dans le bilan des charges :

$$\frac{d\phi_{z,electrode}}{dt} = \Delta_{electrode} \left( \varepsilon_{electrode} I_{app} - J_z \right) \qquad (7)$$

où $\Delta_{,electrode}$ est une grandeur fonctionnelle caractéristique de l'électrode considérée où se déroule la réaction électrochimique z faisant intervenir l'espèce active X. $I_{app}$ est le courant appliqué au système de stockage et $\varepsilon_{electrode}$ une grandeur fonctionnelle caractéristique de l'électrode considérée. $J_z$ est la densité de courant totale traversant l'électrode considérée et est la somme du courant d'insertion $J_{ins,z}$ et de courant de réactions secondaires $J_{secondaire,z}$ ou parasites $J_{para,z}$ de type processus de vieillissement.

- Représentation mathématique de la redistribution des charges à chacune des électrodes dans le modèle électrochimique 0D:

Le phénomène de redistribution des charges dans la profondeur de chaque électrode est pris en compte dans le modèle électrochimique 0D général à l'aide des équations (8)-(10):

$$\frac{d\Delta\Phi_{z,electrode}}{dt} = g_{electrode}\left( I_{app}, J_z \right) - h_{electrode} V_{Rp,electrode} \qquad (8)$$

$$g_{electrode}\left( I_{app}, J_z \right) = \theta_{electrode} \left( I_{app} - \xi_{electrode} J_z \right) \qquad (9)$$

$$\frac{dV_{Rp,electrode}}{dt} = \frac{d\Delta\Phi_{z,electrode}}{dt} - k_{electrode} V_{Rp,electrode} \qquad (10)$$

dans lesquelles $g_{electrode}$, est une fonction mathématique linéaire faisant intervenir le courant appliqué $I_{app}$, ainsi que

la densité de courant de transfert de charge et où $V_{Rp,electrode}$ est le sur potentiel de redistribution des charges dans la profondeur de l'électrode considérée. $h_{electrode}$, $\theta_{electrode}$, $\xi_{electrode}$, et $k_{electrode}$ sont des grandeurs fonctionnelles caractéristiques du matériau d'électrode considérée.

- Représentation mathématique de la diffusion ionique dans la porosité à chacun des compartiments du système dans le modèle électrochimique 0D:

Le modèle électrochimique 0D générique retranscrit le phénomène de diffusion des charges de l'électrolyte dans la porosité des différents compartiments du système électrochimique en intégrant au bilan électrique global des termes de surtensions de concentrations $\eta_{ci}$ qui prennent la forme de l'équation différentielle (11) :

$$\forall i \in N, \frac{d\eta_{ci}}{dt} = \lambda_i(T)\left(I_{app} - \omega_i(T)\eta_{ci}\right) \qquad (11)$$

dans laquelle $\lambda i$ et $\omega i$ sont des fonctions mathématiques exponentielles caractéristiques du système de stockage et reflétant les aspects diffusifs à courts et longs termes. Ces fonctions dépendent de la température pour rendre compte du caractère classique thermiquement activé du processus de diffusion des espèces en présence. Généralement, deux termes de surtensions suffisent à rendre compte des phénomènes diffusifs.

- Vieillissement des systèmes de stockage d'énergie:

Le vieillissement des systèmes de stockage d'énergie se caractérise par une perte de capacité (perte d'énergie) accompagnée d'une augmentation de la résistance interne et des surtensions (perte de puissance), souvent causées par une ou plusieurs réactions parasites de vieillissement. La cinétique des réactions de vieillissement peut être décrite par une expression mathématique analogue à l'équation (2), donnée dans l'équation (12) :

$$J_{para,z}(t,T) = J_{para,z,0}\left\{\frac{\prod_{j=1}^{N'}[P_j]^{O^{p,j}}}{\prod_{j=1}^{N'}[P_j]_{ref}^{O^{p,j}}}\exp\left(\alpha_{ox,z}nK\eta_z(t)\right) - \frac{\prod_{i=1}^{N}[R_i]^{O^{r,i}}}{\prod_{i=1}^{N}[R_i]_{ref}^{O^{r,i}}}\exp\left(-\alpha_{red,z}nK\eta_z(t)\right)\right\}\exp\left(\frac{E_{a,z}}{R}\left(\frac{1}{T} - \frac{1}{T_0}\right)\right) \quad (12)$$

dans laquelle $J_{para,z}$ est la densité de courant de transfert de charge parasite, $J_{para,z,0}$ est la densité de courant d'échange électronique de la réaction parasite z.
La perte de capacité se traduit par une diminution de la concentration maximale des espèces stockées dans le matériau d'électrode selon l'équation (13) :

$$\frac{d}{dt}[X]_{max} = -\chi_{electrode}\left|J_{para,z}\right| \qquad (13)$$

dans laquelle $X_{electrode}$ est une grandeur fonctionnelle caractéristique du matériau d'électrode
La perte de puissance se traduit par une augmentation de la résistance interne du système provoquée notamment par la croissance de couches résistives en surfaces des particules de matières actives selon l'équation (14) :

$$\frac{d}{dt}R_{layer} = \pm\, \chi_{layer}\, \left|J_{para\,,z}\right| \qquad (14)$$

dans laquelle $X_{layer}$ est une grandeur fonctionnelle caractéristique de la composition chimique des couches parasites formées en surface des électrodes par réactivité avec l'électrolyte. Le signe +/- dépend du mécanisme physico-chimique de développement de la couche de surface.

- Bilan thermique:

La température de la cellule peut être calculée comme sortie du bilan d'énergie. D'une part le flux de chaleur interne $\varphi_{gen}$ généré par l'activité de la cellule électrochimique est donné par :

$$\varphi_{gen}(t) = \sum_{z} J_z(t)\left(U_{eq,ref,z}(t) - T(t)\frac{dU_{eq,ref,z}(t)}{dT}\right)A_{(z)} - V(t)I(t) \qquad (15)$$

où le terme $(U_{eq,ref,z}-V)$ peut être associé aux pertes irréversibles pour chaque réaction électrochimique z, tandis que le terme de génération réversible $T\, dU_{eq,ref,z}/dT$ est directement lié aux variations d'entropie dues aux réactions électrochimiques. D'autre part le flux transféré vers l'ambiant à température $T_a$, $\varphi_{tra}$ est donné par la loi de Fourier :

$$\varphi_{tra}(t) = hA_{cell}(T(t) - T_a) \qquad (16)$$

où h est un coefficient de transfert thermique associée aux phénomènes de convection et radiation, et $A_{cell}$ est la surface de la cellule. Le flux thermique net à travers la batterie, $\varphi$, peut être facilement calculé comme différence entre les flux internes et externes, i.e. $\varphi = \varphi_{gen} - \varphi_{tra}$. La quantité de chaleur stockée dans la batterie, obtenue par intégration du flux de chaleur dans le temps, permet de calculer la température de la batterie suivant les relations :

$$M_{cell}C_p\frac{dT(t)}{dt} = \varphi_{gen}(t) - \varphi_{tra}(t) \qquad (17)$$

où $C_p$ est la capacité thermique spécifique de la cellule et $M_{cell}$ sa masse.

- Bilan électrique global:

Le modèle électrochimique 0D générique est complété par un bilan global du potentiel électrique sur la cellule :

$$V(t,T) = \Delta\Phi_{electrode,pos}(t,T) - \Delta\Phi_{electrode,neg}(t,T) + \sum_{i=1}^{N}\eta_{c_i}(t,T) + \eta_{\Omega}(t,T) \qquad (18)$$

dans laquelle $V(t,T)$ est la tension aux bornes de la cellule, $\eta_{ci}$ sont des termes de surtension de concentration et $\eta_{\Omega}$ est une surtension ohmique faisant intervenir la résistance interne du système, résultant des conductivités des phases solide et liquide. La résistance ohmique est une grandeur fonctionnelle caractéristique du système qui prend la forme d'une fonction mathématique exponentielle.

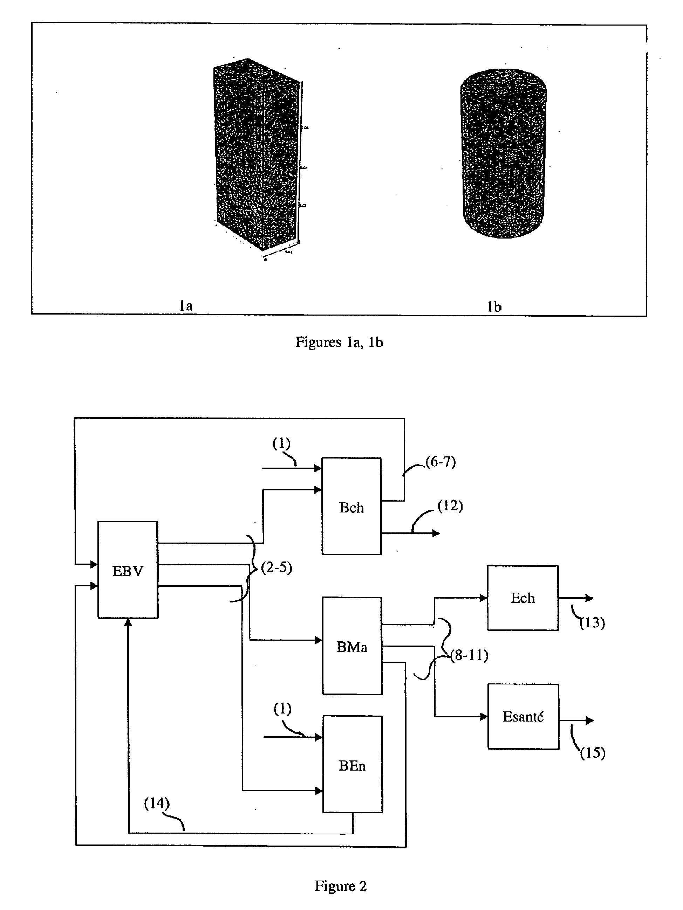

En résumé, le modèle réduit de la méthode selon l'invention illustré sur la figure 2 comprend les équations (1 à 18), soit un total a minima en fonction des réactions électrochimiques prises en considération, d'au moins 16 équations, pour les 16 variables $J_{\&}$, ..., $J_n$, $\eta_1$, ···, $\eta_{n,}$,$[X]^o_{pos}$ $[X]^o_{neg}$ $\Phi_{pos}$, $\Phi_{neg}$,$Vr_{pos}$, $Vr_{neg}$, $\Delta\Phi_{pos}$, $\Delta\Phi_{neg}$,$\eta_1$,$\eta_n$ V, T.

Les autres grandeurs apparaissant dans les équations qui constituent la méthode sont traitées comme des paramètres à calibrer.

- Définition de l'état de charge selon l'invention:

L'état de charge de la cellule dans la méthode selon l'invention, q(t), est donné par la concentration d'une des espèces réactives X selon la relation (19):

$$SOC\ (t) = \gamma + \delta\ \frac{[X]_t}{[X]_{\max}} \tag{19}$$

dans laquelle $\gamma$ et $\delta$ sont des grandeurs fonctionnelles caractéristiques des matériaux d'électrodes.

Ce calcul se distingue nettement du calcul connu dans l'art antérieur dit "coulomb counting", qui donne

$$\frac{dq(t)}{dt} = \frac{I(t)}{Q_{max}} \tag{20}$$

La relation entre $X_{max}$ et $Q_{max}$ est donnée par

$$Q_{\max} = \kappa F [X]_{\max} \tag{21}$$

dans laquelle F est la constante de Faraday, $\kappa$ est une grandeur fonctionnelle caractéristique de la géométrie de l'électrode limitante.

L'estimation de q s'appuie donc sur l'estimation de X, alors que cette variable n'est pas directement mesurable à partir d'une batterie, en particulier à bord du véhicule.

Exemples d'applications aux technologies Ni-MH et Li-ion

1) Cas d'une batterie Ni-MH

Dans le cas d'une batterie Ni-MH, les espèces actives sont l'oxyhydroxyde de Nickel NiOOH, l'hydroxyde de nickel $Ni(OH)_2$, l'hydrure métallique MH, l'oxygène $O_2$ partiellement dissous dans l'électrolyte en équilibre avec la phase gazeuse.

Les réactions électrochimiques à l'électrode positive sont, pendant la décharge: $NiOOH + H_2O + e^- \rightarrow Ni(OH)_2 + OH^-$

$$\tfrac{1}{2}\ O_2 + H_2O + e^- \rightarrow 2OH^- \tag{22}$$

tandis qu'à l'électrode négative,

$$MH + OH^- \rightarrow H_2O + e^- + M$$

$$2OH^- \rightarrow \tfrac{1}{2}\ O_2 + H_2O + 2e^- \tag{23}$$

En appliquant l'équation (2) aux quatre réactions (22)-(23), avec z=1,...4, on obtient:

$$J_1(t) = J_{1,0} \cdot \left\{ \left( \frac{c_n(t)}{c_{n,ref}} \right) \cdot \left( \frac{c_e}{c_{e,ref}} \right) \cdot e^{0.5 \cdot K \cdot \eta_1(t)} - \right.$$
$$\left. - \left( \frac{c_{n,max} - c_n(t)}{c_{n,max} - c_{n,ref}} \right) \cdot e^{-0.5 \cdot K \cdot \eta_1(t)} \right\} \cdot \exp\left( \frac{E_{a,1}}{R} \left( \frac{1}{T} - \frac{1}{T_0} \right) \right) \qquad (24)$$

$$J_2(t) = J_{2,0} \cdot \left\{ \left( \frac{c_e}{c_{e,ref}} \right)^2 \cdot e^{1.5 \cdot K \cdot \eta_2(t)} - \left( \frac{\bar{c}_o(t)}{c_{o,ref}} \right)^{1/2} \cdot e^{-0.5 \cdot K \cdot \eta_2(t)} \right\} \cdot \qquad (25)$$
$$\cdot \exp\left( \frac{E_{a,2}}{R} \left( \frac{1}{T} - \frac{1}{T_0} \right) \right) ,$$

$$J_3(t) = J_{3,0} \cdot \left\{ \left( \frac{c_m(t)}{c_{m,ref}} \right)^{\mu} \cdot \left( \frac{c_e}{c_{e,ref}} \right) \cdot e^{0.5 \cdot K \cdot \eta_3(t)} - \right.$$
$$\left. - e^{-0.5 \cdot K \cdot \eta_3(t)} \right\} \cdot \exp\left( \frac{E_{a,3}}{R} \left( \frac{1}{T} - \frac{1}{T_0} \right) \right) , \qquad (26)$$

$$J_4(t) = J_{4,0} \cdot \left\{ \left( \frac{c_e}{c_{e,ref}} \right)^2 \cdot e^{1.5 \cdot K \cdot \eta_4(t)} - \left( \frac{c_o(t)}{c_{o,ref}} \right)^{1/2} \cdot e^{-0.5 \cdot K \cdot \eta_4(t)} \right\} \cdot \qquad (27)$$
$$\cdot \exp\left( \frac{E_{a,4}}{R} \left( \frac{1}{T} - \frac{1}{T_0} \right) \right) ,$$

dans lesquelles $c_n$ est la concentration des protons dans l'électrode positive (hydroxyde de nickel), $c_e$ est la concentration de l'électrolyte i.e. des ions OH⁻, $c_o$ est la concentration de l'oxygène dans l'électrode négative et la même variable barrée est la concentration interfaciale d'oxygène, en équilibre avec la phase gazeuse, $c_m$ est la concentration de l'hydrogène dans l'électrode négative (matériau métallique), tandis que les indices "ref" et "max" se réfèrent aux valeurs de référence et maximales, respectivement ; enfin $\mu$ représente l'ordre de réaction.

Les surpotentiels $\eta_z$ sont définis comme:

$$\eta_1(t) = \Phi_{pos}(t) - U_{eq,ref,1}(t)$$
$$\eta_2(t) = \Phi_{pos}(t) - U_{eq,ref,2}(t)$$
$$\eta_3(t) = \Phi_{neg}(t) - U_{eq,ref,3}(t) \qquad (28)$$
$$\eta_4(t) = \Phi_{neg}(t) - U_{eq,ref,4}(t)$$

où $\Phi_{pos}$ et $\Phi_{neg}$ sont les différences de potentiel solide-liquide à l'électrode positive et négative, respectivement.

Des expressions pour $U_{eq,ref,1}$, $U_{eq,ref,2}$, $U_{eq,ref,3}$ et $U_{eq,ref,4}$ en fonction de la température sont connues. Par exemple, on connaît:

$$U_{eq,ref,1} = \frac{k_1}{K(T)}(2\theta - 1) + U_1^0 + (T - T_0)\frac{dU_1}{dT} \qquad (28a)$$

où $\theta$ est le SoC, $k_1$ une constante et $U_1$ est caractérisé par sa dérivée par rapport à la température T.

Pareillement, on connaît les expressions paramétrées :

$$U_{eq,ref,z} = U_z^0 + (T - T_0)\frac{dU_z}{dT} \qquad (28b)$$

pour z = 2,...,4.

2) Cas d'une batterie Li-ion

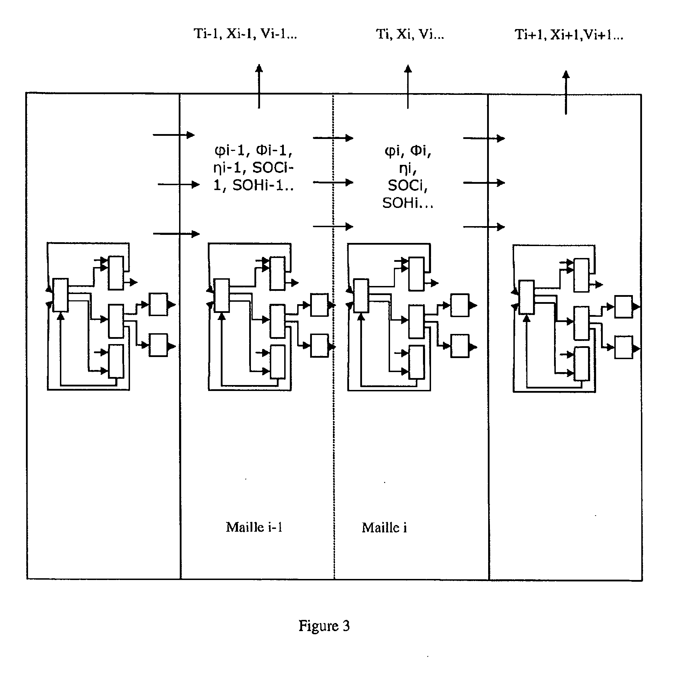

Dans le cas d'une batterie Li-ion, les espèces actives sont des oxydes de métaux pour l'électrode positive et des Composés Carbonés, des Métaux, ou des oxydes de Métaux pour l'électrode négative. Une représentation schématique d'une cellule Li-ion est donnée sur la Fig. 3.

Les réactions électrochimiques à l'électrode positive sont, pendant la charge:

$$Li_{1-x}MO_2 + xe^- + xLi^+ \rightarrow LiMO_2 \qquad (29)$$

tandis qu'à l'électrode négative, en prenant l'exemple d'un composé carboné:

$$Li_yC_6 \rightarrow yLi^+ + 6C + ye^-$$

En appliquant l'équation (2) aux deux réactions (29)-(30), avec z=1,...2, on obtient:

$$J_{ins,pos} = j_{0,ins,pos}\left\{\frac{\overline{C_{pos}}}{C_{pos,ref}} \times \left(\exp\left(\frac{\alpha_{ox,pos}F\eta_{pos}}{RT}\right)\right) - \frac{C_{pos,max} - \overline{C_{pos}}}{C_{pos,max} - C_{pos,ref}} \times \frac{C_e}{C_{e,ref}} \times \left(\exp\left(\frac{\alpha_{red,pos}F\eta_{pos}}{RT}\right)\right)\right\}\exp\left(\frac{E_{a,pos}}{R}\left(\frac{1}{T} - \frac{1}{T_0}\right)\right) \quad (31)$$

$$J_{ins,neg} = j_{0,ins,neg}\left\{\frac{\overline{C_{neg}}}{C_{neg,ref}} \times \left(\exp\left(\frac{\alpha_{ox,neg}F\eta_{neg}}{RT}\right)\right) - \frac{C_{neg,max} - \overline{C_{neg}}}{C_{neg,max} - C_{neg,ref}} \times \frac{C_e}{C_{e,ref}} \times \left(\exp\left(\frac{\alpha_{red,neg}F\eta_{neg}}{RT}\right)\right)\right\}\exp\left(\frac{E_{a,neg}}{R}\left(\frac{1}{T} - \frac{1}{T_0}\right)\right) \quad (32)$$

dans lesquelles $c_{pos}$ est la concentration des ions Li$^+$ dans l'électrode positive (Oxyde métallique), $c_e$ est la concentration de l'électrolyte i.e. des ions Li$^+$, et la même variable barrée est la concentration interfaciale en porteurs de charge, $c_{neg}$ est la concentration des ions Li$^+$ dans l'électrode négative (matériau d'insertion généralement à base de graphite), tandis que les indices "ref" et "max" se réfèrent aux valeurs de référence et maximales, respectivement.

Les surpotentiels $\eta_z$ sont définis comme

$$\eta_{pos} = \phi_{pos} - U_{eq,pos} - R_{SLI,pos} \times J_{pos}$$

$$\eta_{neg} = \phi_{neg} - U_{eq,neg} - R_{SLI,neg} \times J_{neg} \qquad (33)$$

Des expressions pour $U_{eq,pos}$, et $U_{eq,neg}$ en fonction de la température sont connues:

$$U_{eq,pos} = 2.8 - 1.33x + 0.40\exp(-254x) - 0.14\tanh(65(x-0.033)) + (T-T_0)\frac{dU_{pos}}{dT} \quad (33a)$$

$$U_{eq,neg} = 0.12 + 2.5\exp(-70x) - \exp(50(x-1.04)) + (T-T_0)\frac{dU_{neg}}{dT} \quad (33b)$$

Le tableau suivant récapitule les valeurs numériques nécessaires à la calibration du modèle réduit suivant l'invention

- pour un élément prismatique de batterie Ni-MH de capacité 6,5Ah, commercialisé par Panasonic ;

- pour un élément cylindrique de batterie Li-ion de chimie LFP/graphite de capacité 2,3Ah, commercialisé par A123system.

| T=298K | Ni-MH | | Li-ion | |
|---|---|---|---|---|
| Polarité et matériau d'électrode | Electrode (+) NiOOH | Electrode (-) MH | Electrode (+) LiFePO$_4$ | Electrode (-) Carbone |
| J01,ins | 2.1 | 0 | 0.28 | 0 |
| J02,secondaire | 8.0e-08 | 0 | 0 | 0 |
| J03,ins | 0 | 5.4 | 0 | 13.75 |
| J04,secondaire | 0 | 1.5e-011 | 0 | 0 |
| k$_c$ | 0.0035 | 0 | 0 | 0 |
| k$_d$ | 0.0025 | 0 | 0 | 0 |
| β$_{electrode}$ | 1.0516 | 0.4834 | 1.03e+003 | 5.65 |
| ψ$_{elecbode}$ | 4.75e-010 | 0 | 3.73e-014 | 6.85e-012 |
| D$_s$ | 1e-014 | 1e-015 | 2.92e-020 | 2.50e-013 |
| $\Delta_{,electrode}$ | 0.0222 | 0.2059 | 0.74 | 0.028 |
| ε$_{electrode}$ | 0.0903 | -0.3098 | 0.0033 | -0.39 |
| h$_{electrode,}$ | 1.5428e-004 | 0 | 0.0023 | 0.0023 |
| θ$_{electrode,}$ | 0.0020 | -0.0638 | 0.0024 | -0.0112 |
| ξ$_{electrode,}$ | 0.0903 | - 0.3098 | 307.09 | -2.5620 |
| k$_{electrod}$ | 1.7094e-004 | 0 | 0.0018 | 0.0021 |
| λ1 | 1.51e-005 | | 1.44e-011 | |
| ω1 | 176.06 | | 1.81e+009 | |
| R$_{int}$ | 9.0e-04 | | 9.0e-03 | |
| γ | 100 | | 102.11 | |
| δ | -100 | | -126.58 | |
| Acell | 0.0083 | | 0.0063 | |
| Mcell | 0.166 | | 0.07 | |

(suite)

| T=298K | Ni-MH | | Li-ion | |
|---|---|---|---|---|
| Polarité et matériau d'électrode | Electrode (+) NiOOH | Electrode (-) MH | Electrode (+) LiFePO$_4$ | Electrode (-) Carbone |
| Cp | 2000 | | 1750 | |

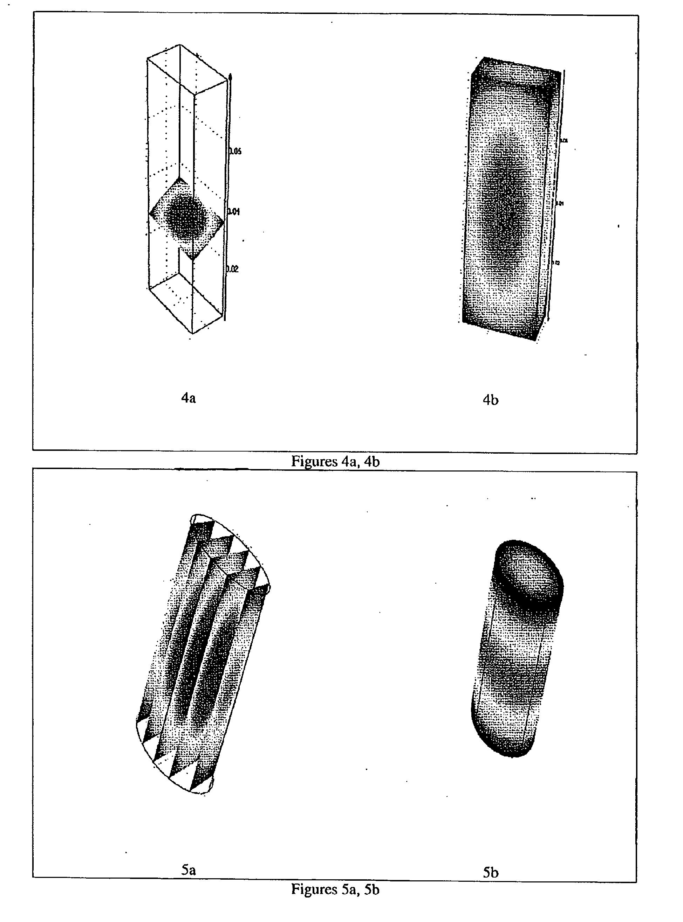

A partir de ces modèles électrochimiques calibrés sur des éléments NIMH PRIUS et Li-ion A123systems, il est possible de procéder au couplage avec un modèle thermique multidimensionnel. A titre d'exemple, les figures 3 et 4 illustrent des résultats de simulation sur ces deux technologies de batteries. Les conditions de refroidissement sont fixées et l'on fait subir aux systèmes différents types de cyclage en courant. L'évolution de la température peut être suivie à chaque pas de temps et en chaque point de l'espace.

La méthode utilise avantageusement un filtre récursif pour estimer l'état du système dynamique à partir des mesures disponibles. Des caractéristiques notoires de ce problème d'estimation sont le fait que les mesures sont affectées par du bruit, et le fait que le système modélisé selon la méthode est fortement non linéaire. Un filtre récursif utilisé de préférence dans la méthode sera le filtre de Kalman étendu connu par l'Homme de l'art.

Selon le modèle de la méthode, le vecteur d'état de la cellule électrochimique de batterie s'écrit $\mathbf{x} = \{c_n, c_m, p_o, \Delta\Phi_{pos}, \Delta\Phi_{neg}, T\}$, dont la première composante est liée a l'état de charge à estimer par l'équation (32). Les mesures disponibles sont la tension aux bornes de la cellule et la température de la batterie, qui représentent la sortie $\mathbf{y}$ du modèle, et le courant I aux bornes qui représente l'entrée $\mathbf{u}$ du modèle. Selon la méthode connue du filtre récursif, les équations du modèle sont réorganisées en:

$$\dot{x} = f(x, u)$$
$$y = h(x, u)$$

$$(34)$$

Algorithme d'estimation du SoC

La méthode prévoit alors une étape où le modèle fournit le vecteur des variations f et la sortie calculée y selon l'équation (34). Ensuite, ces deux *variables sont manipulées par une deuxième étape qui reconstruit l'état Xe à partir de F, Ye, et de la mesure Y. L'algorithme d'estimation utilise ainsi la sortie d'une troisième étape qui fournit la variable L en fonction de l'état reconstruit, des caractéristiques du système électrochimique (selon le modèle de la méthode) et des caractéristiques du bruit qui affecte les mesures. L'étape FNL peut être réalisée avec une méthode connue par l'Homme de l'art, par exemple le filtre de Kalman étendu.*

Le modèle zéro-dimensionnel représente directement l'état de charge comme une variable d'état du modèle. Au contraire, les méthodes connues utilisent des modèles dits "à circuit électrique équivalent", où l'état de charge n'est pas une variable dynamique du modèle, mais une variable exogène, en fonction de laquelle d'autres variables dynamiques ou statiques sont paramétrées. On comprend qu'un système de gestion d'une batterie électrochimique (BMS) utilisant la méthode suivant l'invention pour estimer les caractéristiques non mesurables de la batterie à partir des mesures couramment disponibles fournira en sortie une information plus fiable et plus précise.

*Estimation de l'état de santé selon l'invention*

Le modèle zéro-dimensionnel utilisé dans la méthode selon l'invention est basé sur des paramètres physiques du système, et non sur des paramètres globaux équivalents comme les modèles RC connus dans l'art antérieur. Cette propriété facilite l'estimation du vieillissement et donc de l'état de santé de la batterie.

En fait, les méthodes utilisées pour l'estimation de l'état de charge, qui se basent sur des observateurs d'état, peuvent être étendues pour comprendre une adaptation lente des paramètres du modèle. Cette extension est connue dans l'art antérieur pour plusieurs applications différentes. Dans le cas de l'invention, les mêmes signaux peuvent être utilisés aussi pour cette extension adaptative.

Les variations estimées des paramètres du modèle réduit serviront à détecter d'éventuelles variations macroscopiques dans le comportement de la batterie, et donc des altérations de ses performances, ce qui est communément entendu comme "vieillissement". La reconnaissance et la quantification du vieillissement, à travers les variations relatives des paramètres, donne l'estimation recherchée de l'état de santé.

*Simulateur du comportement électrique et thermique d'une batterie*

Le modèle électrochimique utilisé au sein de chaque maille dans la méthode selon l'invention peut calculer les variations dans le temps de toutes les variables électrochimiques internes de la batterie, et en particulier de l'état de charge. Comme l'entrée du modèle est le courant aux bornes de la batterie, les cas simulés dépendent du choix de cette dernière variable. Par exemple, on peut représenter une charge ou une décharge contrôlée à courant constant, ou à courant variable selon un profil fixé, ou encore à courant variable en fonction de la tension. Ce dernier cas est représentatif des conditions de sollicitation de la batterie dans un véhicule, où le courant imposé à la batterie dépend de la tension, selon les caractéristiques des composants électriques associés (électronique de puissance, moteur(s) électrique(s), etc.).

La présence du bilan d'énergie dans le modèle réduit selon l'invention permet de simuler l'évolution thermique du système, couplé avec l'évolution de l'état électrique donné par l'équation (17). Des résultats typiques de prédiction du comportement thermique du simulateur utilisant les modèles suivant l'invention sont présentés sur les figures 4a et 4b pour le cas de la batterie Ni-MH de l'exemple 1 et sur les figures 5a et 5b pour le cas de la batterie Li-ion de l'exemple 2.

Par conséquence, la méthode selon l'invention peut ainsi servir pour le dimensionnement de la batterie, la définition, la calibration et la validation des stratégies de management électrique et thermique, enfin l'optimisation des systèmes de gestion thermique, qui doivent nécessairement équiper la batterie elle-même. En fait, les flux thermiques générés et la température de la batterie sont des variables d'entrée pour ces systèmes, qui ont pour but le réglage de ces flux et de cette température autour des valeurs admissibles.

La représentation des transitoires thermiques permet ainsi de synthétiser et valider les stratégies de contrôle et optimisation associés aux systèmes de gestion thermiques. Ces stratégies peuvent ainsi profiter de la présence d'un modèle réduit pendant leur utilisation en ligne, pour avoir des estimations de certaines variables qui ne sont pas mesurables (températures dans des points spécifiques, flux thermiques, etc.), ou qui sont mesurables, mais avec des temps de réponse des capteurs associés trop lents.

Description de la méthode multidimensionnelle de simulation du comportement thermique d'un système électrochimique:

La présente invention concerne une méthode de simulation du comportement thermique d'un système électrochimique à l'aide d'un modèle mathématique multidimensionnel permettant notamment de coupler les comportements électriques et thermiques de la batterie en fonctionnement. La reconstruction des caractéristiques thermiques de la batterie est faite à travers l'utilisation d'un modèle mathématique multidimensionnel de la batterie utilisant la technique des éléments finis. Le flux thermique est généré en chaque point de l'espace par un modèle électrochimique à paramètres concentrés de la batterie, ce dernier permettant notamment de coupler les comportements électriques et thermiques de la batterie en fonctionnement.

La méthode peut être utilisée hors ligne, par exemple dans le cadre du dimensionnement d'une batterie, du dimensionnement de son système de refroidissement, de l'optimisation des stratégies de gestion énergétique et thermique en fonction de l'application visée. La méthode peut également être utile d'une façon synchrone au fonctionnement de la batterie elle-même (temps réel) pour estimer la température interne d'un élément, par exemple lors d'une recharge rapide.

Dans la modélisation multidimensionnelle par éléments finis de la méthode selon l'invention, les phénomènes thermiques et électriques sont pris en compte grâce à la mise en oeuvre dans chaque maille d'un modèle électrochimique 0D de la batterie. Le modèle électrochimique 0D dont les équations représentatives sont décrites ci-dessus (suivant l'approximation à paramètres concentrés) comprend une description mathématique des réactions de la batterie qui permet de rendre compte de son comportement dynamique (électrique et thermique), sous courant fort et sous courant nul, avec une précision accrue. Le flux thermique est généré en chaque point de l'espace par le modèle électrochimique 0D en fonction des réactions chimiques endothermiques ou exothermiques. Il est intégré à chaque pas de temps en fonction des caractéristiques thermiques du système (notamment conductivité thermique, capacité thermique des matériaux) et géométriques. Les transferts thermiques à l'intérieur du système font intervenir le phénomène de conduction et les transferts avec l'extérieur (limites géométriques) sont modulables via les équations de conduction et de convection du fluide de refroidissement considéré (air, eau-glycol).

Description des figures:

Les figures 1 à 5 illustrent l'invention à titre non limitatif.

Les figures 1a et 1b représentent un maillage 3D pour les modèles thermiques sur des géométries prismatiques et cylindriques. Les maillages utilisés sont typiques des méthodes de modélisation par éléments finis. L'espace de la géométrie d'étude est discrétisé et divisé en de plus petits sous ensembles qui permettent de définir en leur intersection des points de mailles sur lesquels seront effectués les calculs. En effet, en chaque point de ces maillages les calculs seront effectués à chaque pas de temps et les variations des variables d'état des modèles électrochimiques et thermiques seront obtenues selon la méthode explicitée.

La figure 2 donne une représentation schématique du modèle électrochimique 0D qui est utilisé dans la méthode , où les sigles ont la signification suivante :

EBV: Équations de Butler-Volmer (équation 2) qui décrivent la cinétique des réactions électrochimiques;

(1): $I_{app}$ est le courant appliqué à la cellule;

(2): $J_z$ est la densité de courant pour la réaction chimique z;

(3): $J_{z+k}$ est la densité de courant pour la réaction chimique z+k;

(4): $J_{z+k+i}$ est la densité de courant pour la réaction chimique z+k+1;

(5): $J_n$ est la densité de courant pour la réaction chimique n;

BCh: bilan de charge -représente les équations du bilan de charge électrique;

(6): $\Phi_{pos}$ est le surpotentiel à l'interface du matériau d'électrode positive;
(7): $\Phi_{neg}$ est le surpotentiel à l'interface du matériau d'électrode négative;

BMa: bilan de matière -représente les équations du bilan de matière et de conservation de la masse;

(8): $[X]^o_{pos}$ est la concentration de surface de l'espèce X à l'électrode positive;

(9): $[X]^o_{neg}$ est la concentration de surface de l'espèce X à l'électrode négative;

(10): $[X]_{z,pos,max}$ est la concentration maximale de l'espèce X dans l'électrode positive;

(11): $[X]_{z,neg,max,}$ est la concentration maximale de l'espèce X dans l'électrode négative;

(12): V; est le potentiel aux bornes de la cellule électrochimique;

(13): SOC;est l'état de charge de la batterie (State of Charge);

Ech: état de charge -erprésente l'ensemble des équations donnant l'état de charge du système;

Esanté: état de santé -représente l'ensemble des équations donnant l'état de santé du système;

BEn: bilan d'énergie -représente l'ensemble des équations donnant l'évolution de la température en fonctions des flux thermique Phi générés lors du fonctionnement de la batterie;

(14): T est la température du système;

(15): SOH est l'état de santé de la batterie (State of Health).

Le courant aux bornes de la cellule est considéré comme une entrée du modèle, tandis que la tension est une de ses sorties. Les signaux d'entrée, courant et température, sont représentatifs de quantités physiques mesurées sur la batterie. Des moyens de traitement basés sur les équations de Butler Volmer, le bilan des charges, le bilan de matière et le bilan énergétique, calculent l'état de la batterie sur la base des signaux d'entrée et génèrent des signaux de sortie dérivés du calcul, comme le potentiel, l'état de charge, l'état de santé et la température.

La figure 3 représente le couplage entre un modèle électrochimique 0D tel qu'explicité en figure 2 et un modèle thermique en chaque maille du modèle multidimensionnel.

Les figures 4a et 4b sont une représentation 3D d'une cellule de batterie Ni-MH, de type PRIUS. Le modèle 3D est renseigné avec les dimensions du système d'étude ainsi que les propriétés thermiques des matériaux d'électrode. La simulation sur le cas d'une charge à régime fixé donne la répartition de la Température (K) en fin de charge (Surcharge). Pour les batteries de type Ni-MH, une forte augmentation de température apparaît en fin de surcharge (figutr 4b) en raison de la production/recombinaison de l'oxygène dégagé par les réactions secondaires. L'effet coeur/peau en fin de surcharge est directement visible par la différence de couleur entre le centre du système et la peau.

Les figures 5a et 5b montrent un autre cas d'utilisation de la méthode de simulation du comportement thermique selon l'invention couplant la modélisation électrochimique 0D à la modélisation multidimensionnelle thermique par éléments finis pour une géométrie cylindrique et pour une technologie de type Li-ion. Le modèle 3D est renseigné avec les dimensions du système d'étude ainsi que les propriétés thermiques des matériaux d'électrode. Les gradients thermiques internes au système sont représentés par des variations de teintes colorées en noir et blanc sur les figures 5a et 5b.

Avantages de la méthode selon l'invention

La simulation multidimensionnelle du comportement thermique des systèmes de stockage d'énergie électrique en fonctionnement, avec un couplage entre les aspects électriques et thermiques, présente plusieurs avantages.

Hors ligne, elle permet de définir une géométrie de pack de batterie, de dimensionner le système de refroidissement, et d'éviter des surdimensionnements de sécurité des batteries ou du refroidissement. On peut ainsi, sauvegarder du poids à bord et, en conséquence, économiser du carburant consommé. Elle permet également de réduire le coût total du véhicule.

Cette simulation permet également d'optimiser les stratégies de gestion électrique et thermiques afin de garantir la sécurité du pack de batterie et des prestations fonctionnelles (puissance et énergie) optimisées. En respectant les limites en gradient thermique interne à chaque élément et entre éléments au sein du pack, la simulation permet d'éviter que le logiciel de supervision du véhicule ne soit amené à se comporter d'une façon trop prudente dans l'utilisation du potentiel d'énergie de la batterie, ou inversement. Ceci permet en conséquence d'augmenter la durée de vie du pack.

Un simulateur multidimensionnel correct de la thermique de la batterie, transcrivant les gradients thermiques internes aux éléments et les gradients thermiques entre éléments, constitue donc une garantie pour une exploitation efficace et sûre de la capacité de la batterie dans toute la plage de fonctionnement du véhicule.

La simulation multidimensionnelle du comportement thermique d'une batterie peut également être utile d'une façon synchrone à son fonctionnement (temps réel), par exemple lors d'une recharge rapide où les niveaux de courant élevés tendent à échauffer fortement le système électrochimique. En respectant les limites en gradient thermique interne à chaque élément et entre éléments au sein du pack, la simulation permet d'éviter que le chargeur de la batterie ne soit amené à appliquer des niveaux de courant trop élevés sur la batterie, ou inversement permet de gagner du temps de recharge en optimisant le niveau de courant appliqué.

Simulateur du système véhicule

La méthode selon l'invention est aussi utile comme aide au dimensionnement des chaînes de motorisation pour véhicules hybrides. Typiquement, ces applications ont besoin de modèles de comportement d'une batterie à paramètres concentrés capables de simuler le comportement dynamique d'une batterie de traction plus efficacement et fidèlement que des modèles de type circuit électrique équivalent. La méthode de simulation multidimensionnelle du comportement thermique d'une batterie telle que décrite précédemment peut être utilisée avantageusement dans un simulateur de véhicule hybride ou électrique.

Procédé de production d'une batterie

Tout procédé de production d'une batterie qui s'appuiera sur un simulateur du comportement électrique et thermique d'une batterie selon l'invention tirera avantageusement parti de son temps de calcul minimisé, sa fiabilité et sa précision sur la prédiction des caractéristiques d'une batterie. L'invention s'applique avantageusement à un procédé de fabrication d'une batterie électrochimique dans lequel on dimensionne préalablement la batterie au moyen de la méthode de simulation multidimensionnelle précédemment décrite.

**Revendications**

1. Méthode de simulation du comportement thermique d'un système électrochimique rechargeable comportant des électrodes, un séparateur et un électrolyte, dans laquelle on dispose d'au moins un signal d'entrée d'au moins un paramètre représentatif d'une quantité physique dudit système, et on établit un modèle électrochimique dudit système comprenant au moins :

   ■ une représentation mathématique d'une cinétique de réactions électrochimiques ayant lieu aux interfaces entre chacune des électrodes et l'électrolyte, ladite représentation prenant en compte des concentrations d'interface,
   ■ une représentation mathématique d'une accumulation spatiale de capacité de double couche de charges à chaque électrode,
   ■ une représentation mathématique d'une redistribution de charges à chacune des électrodes,
   ■ une représentation mathématique d'une diffusion de charges ioniques de l'électrolyte au travers desdites électrodes et dudit séparateur,
   ■ un bilan de matière dans toutes phases du système,
   ■ un bilan énergétique du système, pour calculer une température dudit système électrochimique,

   **caractérisée en ce que** :

   ○ ledit modèle électrochimique est un modèle à paramètres concentrés dans lequel lesdits paramètres sont homogènes au sein desdites électrodes et au sein dudit séparateur,
   ○ on définit un maillage spatial du système électrochimique en découpant ledit système en éléments géométriques de petites dimensions,
   ○ on établit un modèle mathématique multidimensionnel dudit système électrochimique par la technique des éléments finis en discrétisant des équations comportementales dudit système en chaque maille dudit maillage spatial,
   ○ on génère un flux thermique en chaque maille par ledit modèle électrochimique en fonction de réactions chimiques endothermiques ou exothermiques, ledit flux étant intégré à chaque pas de temps en fonction de caractéristiques thermiques et géométriques dudit système,
   ○ on calcule des variables caractéristiques dudit système à chaque pas de temps et en chaque maille,
   ○ on simule ledit comportement thermique du système électrochimique en générant au moins un signal de sortie représentatif du comportement thermique du système à partir desdites variables caractéristiques du système.

2. Méthode selon la revendication 1, dans laquelle ledit modèle électrochimique tient compte d'un vieillissement dudit système électrochimique en déterminant une diminution de concentration maximale d'espèces stockées dans lesdites électrodes, et une augmentation d'une résistance interne dudit système électrochimique.

3. Méthode selon la revendication 2, dans laquelle on détermine la diminution de concentration maximale $[X]_{max}$ au moyen de la formule suivante :

$$\frac{d}{dt}\big[X\big]_{\max} = -\chi_{electrode}\ \big|J_{para,z}\big|$$

   dans laquelle $\chi_{electrode}$ est une grandeur fonctionnelle caractéristique de matériaux constituant chaque électrode, t représente le temps, et $|J_{para,z}|$ représente une densité de courant de transfert de charge parasite pour une réaction z.

4. Méthode selon l'une des revendications 2 et 3, dans laquelle on détermine l'augmentation de résistance interne $R_{layer}$ au moyen de la formule suivante

$$\frac{d}{dt} R_{layer} = \pm \chi_{layer} \left| J_{para,z} \right|$$

dans laquelle $\chi_{layer}$ est une grandeur fonctionnelle caractéristique d'une composition chimique de couches parasites formées en surface des électrodes par réactivité avec l'électrolyte, le signe +/- dépendant du mécanisme physico-chimique de développement de couche de surface, t représente le temps, et $|J_{para,z}|$ représente une densité de courant de transfert de charge parasite pour une réaction z.

5. Méthode selon l'une des revendications précédentes, dans laquelle ledit système électrochimique rechargeable comporte également un compartiment destiné à recueillir des espèces gazeuses, et lesdits paramètres sont homogènes au sein dudit compartiment.

6. Méthode l'une des revendications précédentes, dans laquelle on distingue la concentration interfaciale et la concentration moyenne C=f(t) pour chaque espèce active dans chaque région du système électrochimique dans le modèle 0D.

7. Méthode selon l'une des revendications précédentes dans laquelle on décrit le potentiel d'équilibre thermodynamique de chaque électrode du modèle 0D par une relation mathématique thermodynamique (Nernst, Margules, Van Laar, Redlich-Kister) ou analytique (par exemple: polynomiale ou exponentielle).

8. Méthode selon l'une des revendications précédentes dans laquelle on recueille comme signal de sortie le potentiel et/ou l'état de charge et/ou l'état de santé et/ou la température en tout point de l'espace du système électrochimique.

9. Simulateur du comportement thermique d'une batterie électrochimique comprenant :

○ un moyen d'entrée pour recevoir une valeur d'entrée d'au moins un paramètre représentatif d'une quantité physique d'une batterie;
○ un moyen de traitement pour obtenir au moins une caractéristique de sortie calculée par la méthode selon l'une des revendications 1 à 8.

10. Système de gestion intelligent d'une batterie électrochimique comprenant

- un moyen d'entrée connecté à un moyen de mesure sur la batterie pour recevoir une valeur d'entrée d'au moins un paramètre représentatif d'une quantité physique de la batterie,
- un moyen de traitement pour obtenir au moins un signal de sortie d'au moins une caractéristique calculée par la méthode selon l'une des revendications 1 à 8,
- un moyen de contrôle pour commander la charge/décharge et/ou le refroidissement de la batterie en réponse au signal de sortie du moyen de traitement et/ou de comparaison.

11. Système de gestion selon la revendication 10 dans lequel le moyen de traitement comprend un filtre récursif.

12. Utilisation du système de gestion selon l'une des revendications 10 ou 11 pour le contrôle et la gestion d'énergie d'un système électrochimique rechargeable d'un véhicule électrique ou hybride, ou d'une installation de fourniture d'énergie photovoltaïque ou éolien.

13. Utilisation du système de gestion selon l'une des revendications 10 ou 11 pour le contrôle et la gestion d'un chargeur/déchargeur.

14. Utilisation de la méthode selon l'une des revendications 1 à 8 pour simuler le comportement thermique et électrique d'un système électrochimique rechargeable d'un véhicule électrique ou hybride, ou d'une installation de fourniture d'énergie photovoltaïque ou éolien.

15. Utilisation de la méthode selon l'une des revendications 1 à 8 pour le dimensionnement et la conception d'ensemble d'une batterie.

**16.** Utilisation selon la revendication 15, pour l'établissement des moyens de gestion thermique de refroidissement et/ou de chauffage d'une batterie.

Figures 1a, 1b

Figure 2

Ti-1, Xi-1, Vi-1...    Ti, Xi, Vi...    Ti+1, Xi+1,Vi+1...

φi-1, Φi-1, ηi-1, SOCi-1, SOHi-1..

φi, Φi, ηi, SOCi, SOHi...

Maille i-1    Maille i

Figure 3

4a

4b

Figures 4a, 4b

5a

5b

Figures 5a, 5b

**EP 2 293 091 A2**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 880710 A, Philips